# EUROPEAN PATENT SPECIFICATION

(11) **EP 2 709 160 B1**
(45) Date of publication and mention of the grant of the patent: **30.03.2016**
(21) Application number: 12184514.3
(22) Date of filing: 14.09.2012
(51) Int. Cl.: H01L 31/0224, H01L 31/18

(54) **Method for metallization of solar cell substrates**
Verfahren zur Metallisierung von Solarzellensubstraten
Procédé de métallisation de substrats de cellules solaires

(43) Date of publication of application: 19.03.2014
(73) Proprietor: Atotech Deutschland GmbH, 10553 Berlin (DE)
(72) Inventor: Voss, Dr. Torsten, 16548 Glienicke (DE); Matejat, Kai-Jens, 14109 Berlin (DE); Sperling, Jan, 12167 Berlin (DE); Lamprecht, Sven, 10589 Berlin (DE); Schoenenberger, Catherine, 68510 Sierentz (FR)
(74) Representative: Wonnemann, Jörg

(56) References cited:
- EP-A1- 2 405 469
- EP-A2- 2 068 354
- EP-A2- 2 157 209
- WO-A1-2009/145857
- WO-A1-2012/016932
- US-A1- 2011 147 707
- US-B1- 7 339 110

## Description

### Field of the Invention

The present invention relates to a method for metallization of solar cell substrates, particularly solar silicon substrates.

### Backaround of the Invention

Solar cell substrates such as doped silicon substrates comprise metallic features such as conducting lines, contact pads and solder pads attached to one or both sides of the substrate surface. Such metallic features are required for electrically coupling an external electrical circuit to doped regions of the solar cell substrate.

Preferably, the contacting lines, contact pads and solder pads are made of copper because of the high electrical conductivity. Such metal features can be deposited by vapour phase deposition methods such as physical vapour phase deposition (PVD), chemical vapour phase deposition (CVD), screen printing of metal containing conductive pastes or by means of wet chemical deposition such as electroplating. A selective deposition of the metal or metal alloy onto the solar cell substrate is necessary in all cases. Accordingly, different kinds of masks are applied during metal or metal alloy deposition such as polymeric resist materials in case of electroplating.

Recent solar cell substrates are very thin, e.g., less than 200 µm or even less than 100 µm in thickness and very brittle. Hence, the substrate handling during metal and metal alloy deposition is cumbersome, especially when the metal or metal alloy is deposited by electroplating which requires electrically contacting the substrate with clamps and the like.

Furthermore, a narrow thickness distribution of metal or metal alloy features deposited onto the silicon substrate is demanded.

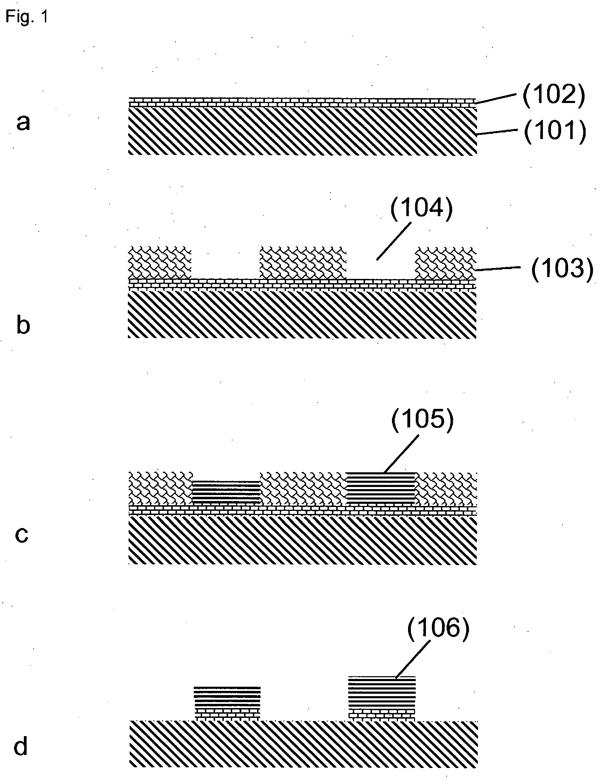

A method for selectively electroplating a metal onto a solar cell substrate is disclosed in US 7,339,110 B1 and US 7,388,147 B2. The method disclosed therein is shown in Fig. 1. A plating base (102) is deposited by physical vapour deposition onto the backside of a solar cell substrate (101) (Fig. 1a). The plating base can be a multilayer stack providing several functionalities such as light reflection, barrier against undesired diffusion of atoms, and a layer providing a platable surface. A preferred plating base (the outermost layer in case of a multilayer stack) is preferably a thin layer of copper. Next, a photo resist (103) is attached to the plating base (102) and patterned (Fig. 1b). A metal layer (105), preferably a copper layer is deposited into the openings (104) of the patterned photo resist layer (103) (Fig. 1 c) followed by removal of the patterned photo resist (103) and etch back of those parts of the plating base which are not coated with the metal layer (105) resulting in conducting lines (106) (Fig. 1d).

The main disadvantage of the method shown in Fig. 1 is the inhomogeneous thickness distribution of the conducting lines (106) obtained. The poor thickness distribution is caused by variation of the local electrical potential which is strongly dependent on the layout of the patterned lines.

### Objective of the Invention

Hence, it is the objective of the present invention to provide a method for electroplating a metal or metal alloy onto one or both sides of a solar cell substrate which results in a homogeneous thickness distribution of plated conducting lines, contact pads and solder pads.

### Summary of the Invention

This objective is solved by a method for metallization of a solar cell substrate comprising, in this order, the steps of
(i) providing a solar cell substrate (201) having a plating base (202) on at least a portion of one surface of said substrate (201),
(ii) depositing a first resist layer (203) onto the whole substrate (201) including the edges and side walls of said substrate (201) and patterning said first resist layer (203) and thereby forming first openings (204) which expose at least a portion of the plating base (202),
(iii) forming a conductive seed layer (205) on top of the patterned first resist layer (203) and on those portions of the plating base which are exposed by the first openings (204),
(iv) electroplating a first metal or metal alloy layer (206) onto the conductive seed layer (205) formed in step (iii),
(v) etching away an amount of the first metal or metal alloy layer (206) sufficient to remove the first metal or metal alloy layer (206) from the patterned first resist layer (203) leaving a patterned first metal or metal alloy layer (206) in the first openings (204),
(vi) etching away the conductive seed layer (205) from the patterned first resist layer (203), and
(vii) removing the patterned first resist layer (203).

The patterned first metal or metal alloy layer obtained by the method according to the present invention has the desired narrow and homogeneous thickness distribution.

### Brief Description of the Figures

Figure 1 shows a method for depositing a patterned first metal or metal alloy layer on one side of a solar cell substrate according to the prior art.
Figure 2 shows a method for depositing a patterned first metal or metal alloy layer on one side of a silicon substrate according to the present invention.
Figure 3 shows a first method to deposit a second metal or metal alloy layer on top of a first metal or metal alloy layer.
Figure 4 shows a second method to deposit a second metal or metal alloy layer on top of a first metal or metal alloy layer.
Figure 5 shows a method for depositing a cap layer onto a patterned first metal or metal alloy.

### Detailed Description of the Invention

The invention provides a method for forming a patterned metal or metal alloy layer on a solar cell substrate by electroplating. The method is particularly suitable for fabricating conducting lines, contact pads and solder pads on solar cell substrates. The method is in more detail described below.

The figures shown herein are simply illustrative of the process. The figures are not drawn to scale, i.e. they do not reflect the actual dimensions or features of the solar cell substrate. Like numbers refer to like elements throughout the description.

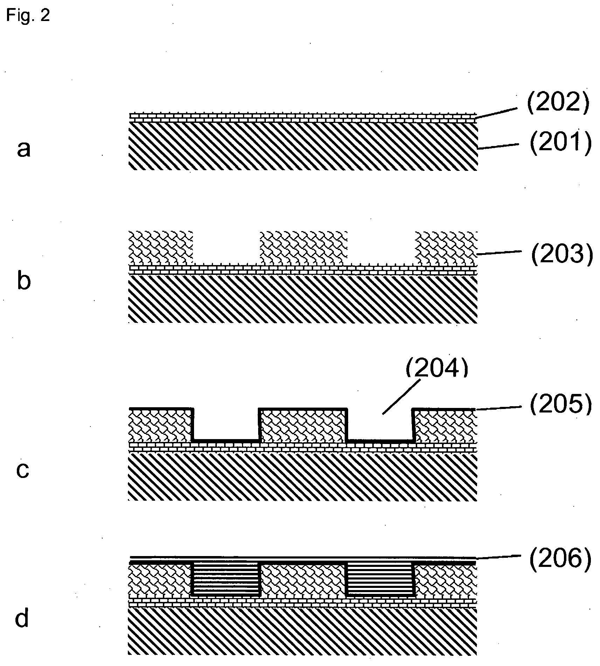

A solar cell substrate (201) having a plating base (202) on one or both outer surfaces is provided (Fig. 2a).

The solar cell substrate (201) can be a silicon wafer ("solar silicon" wafer), an amorphous silicon cell, a polycrystalline silicon cell, a heterogenous laminate assembly of a solar silicon wafer embedded or at least stabilized already from one side with a material such as ethylvinylacetate (EVA), all of which are referred to herein as silicon-based solar cell substrates. The solar cell substrate (201) may also be any other inorganic or organic thin film solar cell material. Preferably, the solar cell substrate (201) is a silicon-based solar cell substrate. Most preferably, the solar cell substrate (201) is a "solar silicon" wafer substrate.

Different types of a plating base (202) can be used in the method according to the present invention. The plating base (202) is defined herein as a portion of a solar cell substrate (201) surface which is subjected to deposition of metal or metal alloy layer(s) thereon in later process steps. Accordingly, the plating base (202) provides a plateable surface.

A first type of plating base (202) is the surface of a solar silicon wafer or portion thereof, particularly consisting of doped silicon. For example, deposition of a nickel alloy layer such as a nickel phosphorous alloy layer by electroless plating onto a highly n-doped silicon surface can be achieved.

A second type of a suitable plating base (202) is a thin metal layer such as a copper layer which may be deposited by a vapour phase deposition method such as physical vapour deposition or by electroless plating onto the solar cell substrate (201). The plating base (202) may also be a multilayer stack of more than one individual metal and metal alloy layer, such as an aluminium layer attached to the solar cell substrate (201) followed by a barrier layer such as a tungsten-tantalum alloy layer or a nickel (alloy) layer and attached thereon a copper layer as the outermost layer of the plating base (202). Preferably, a plating base (202) comprising copper is separated from the surface of a solar silicon wafer by a barrier layer.

A third type of a suitable plating base (202) is a metal silicide layer attached to one or both outer surfaces of a solar silicon wafer as solar cell substrate (201). A method for manufacturing such a metal silicide layer as the plating base (202) is disclosed in US 2011/0318872 A1. Such a metal silicide layer can be prepared by a method comprising a) forming a porosified area in at least an area of the surface of a silicon solar cell substrate by chemical or electrochemical etching, b) coating the porosified area with a thin metal layer, and c) heating the porosified area and the thin metal layer to a temperature of between 250 to 700°C until a metal silicide layer forms in at least a part of the porosified area. The metal silicide area formed by this method then serves as a plating base (202).

The surface of the substrate (201) may be masked prior to step b) in order to only expose the porosified areas for deposition of the thin metal layer in step b). Preferably, said thin metal layer comprises one or more of nickel, silver and copper. Preferably, said metal silicide layer formed in step c) is selected from the group consisting of nickel silicides, silver silicides and copper silicides.

A fourth type of a suitable plating base (202) is a barrier layer which suppresses undesired diffusion of atoms between the solar cell substrate (201) and the conductive seed layer (205) and/or the first metal or metal alloy layer (206). Such a barrier layer may be deposited onto the solar cell substrate (201) by electroless plating or a vapour phase deposition method such as physical vapour deposition. Materials suitable as a barrier layer are for example nickel, nickel alloys, such as nickel-phosphorous alloys, nickel-boron alloys, nickel-tungsten-phosphorous and nickel-molybdenum-phosphorous alloys, cobalt, cobalt alloys such as cobalt-tungsten-phosphorous alloys and cobalt-molybdenum-phosphorous alloys, chromium, titanium, tantalum, tungsten, silver, gold, palladium, and multilayers thereof.

A fifth type of a suitable plating base (202) is a transparent conductive oxide such as indium-doped tin oxide and aluminium-doped zinc oxide which can be deposited by a vapour phase deposition method or a wet chemical deposition method.

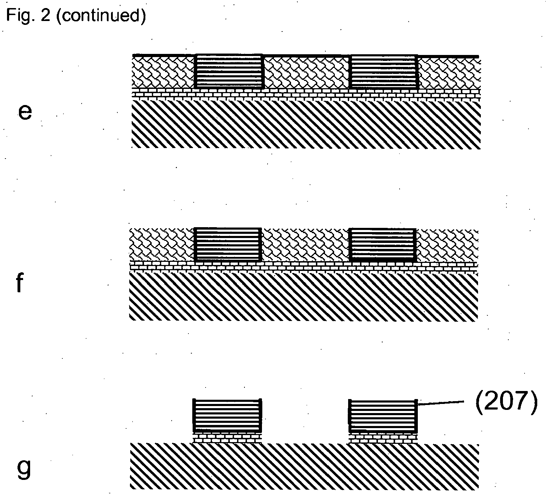

The plating base (202) may completely cover one or both sides of the solar cell substrate (201) or form a pattern on one or both sides of the solar cell substrate (201). In Figs. 2 to 5 a plating base (202) completely covering one side of a solar cell substrate (201) is shown. In such a case, those portions of the plating base (202) which will not be covered with a first metal or metal alloy layer (206) in step (iv) have to be removed later by e.g. wet or dry chemical etching. Otherwise, circuit shorts between adjacent conducting lines are likely to occur.

Next, a first resist layer (203) is deposited onto at least one outer surface of the solar cell substrate and patterned in order to expose at least a portion of the plating base (202).

In one embodiment of the present invention, the solar cell substrate (201) comprises a plating base (202) and a first resist layer (203) on one side of the solar cell substrate (201).

In another embodiment of the present invention, the solar cell substrate (201) comprises a plating base (202) and a first resist layer (203) on both sides of the solar cell substrate (201).

The first resist layer (203) can be attached in form of a liquid resist material by e.g. dip coating, curtain coating or spin coating. Printable resist materials can be deposited by screen printing and dry film resist material may be laminated onto the surface of the solar cell substrate. All such resist deposition methods are known in the art.

First openings (204) are already formed during deposition of the first resist layer (203) in case the first resist layer (203) is deposited by screen printing.

In case another deposition method is used to form the first resist layer (203) other means for patterning, such as photo structuring, plasma erosion, and laser ablation may be applied. All these methods are known in the art. First openings (204) exposing at least a portion of the plating base (202) are thereby formed.

In case a patterned plating base (202) is attached to one or both sides of the solar cell substrate (201), the first openings (204) expose at least a portion of said patterned plating base (202).

In one embodiment of the present invention, the first resist layer (203) is deposited onto the whole substrate (201) including the edges and side walls of said substrate (201). The first resist layer (203) may be deposited onto the whole substrate (201) by dip coating.

The material used for the first resist layer (203) must sustain the plating operations applied in steps (iii) and (iv) which may comprise treatment with acidic and alkaline liquids and/or oxidizing chemicals.

The first resist layer (203) is selected from materials such as liquid resists, printable resists, and dry film resists.

Suitable polymers for the first resist layer (203) are for example one or more of acrylates, ethylene/ethylacrylate copolymer (EEAC), ethylene/methacrylate copolymer (EMA), ethylene/acrylic acid copolymer (EAA), ethylene/butylacrylate copolymer (EBA), polymethylpentene (PMP) and polymethylmethacrylate (PMMA).

More preferred polymer materials for the first resist layer (203) are selected from the group consisting of acrylates and polymethylpentene.

Most preferred polymer material for the first resist layer (203) are acrylates with a weight average molecular weight M_{w} of 20,000 to 200,000 g/mol, more preferably from 25,000 to 150,000 g/mol, and most preferably from 30,000 to 100,000 g/mol. The Tg (glass temperature) of the polymer is preferably in the range of 20 to 130 °C, more preferably from 30 to 120 °C, and most preferably from 40 to 110 °C, as measured according to ISO11357-1.

A molecular weight too high will lead to a reduced solubility in the chosen solvent. With a molecular weight too low, the sensitivity to the process solutions (acidic, alkaline, oxidizing) tends to be insufficient. The Tg must also not be too low because in this case the sensitivity to the substrate is insufficient at the elevated temperature of the processing chemicals.

Optionally, fillers can be incorporated into the polymeric material of the first resist layer (203). Suitable fillers are preferably selected from the group consisting of aluminium borate, aluminium oxide, aluminium trihydroxide, anthracite, sodium antimonate, antimony pentoxide, antimony trioxide, apatite, attapulgite, barium metaborate, barium sulfate, strontium sulfate, barium titanate, bentonite, beryllium oxide, boron nitride, calcium carbonate, calcium hydroxide, calcium sulfate, carbon black, clay, cristobalite, diatomaceous earth, dolomite, ferrites, feldspar, glass beads, graphite, hydrous calcium silicate, iron oxide, kaolin, lithopone, magnesium oxide, mica, molybdenum disulfide, perlite, polymeric fillers such as PTFE, PE, polyimide, pumice, pyrophyllite, rubber particles, fumed silica, fused silica, precipitated silica, sepiolite, quartz, sand, slate flour, talc, titanium dioxide, vermiculite, wood flour, wollastonite, zeolithes, zinc borate, zinc oxide, zinc stannate, zinc sulfide, aramid fibers, carbon fibers, cellulose fibers, and glass fibers and mixtures thereof.

More preferably optional filler materials for the first resist layer (203) are selected from the group consisting of fused silica, fumed silica, precipitated silica, dolomite, kaolinite, talc, calcium carbonate, mica, feldspar, vermiculite, and pumice.

Most preferably, optional filler materials for the first resist layer (203) are selected from the group consisting of kaolinite, talc, mica, and feldspar.

The amount of optional filler in the overall first resist material formulation after removal of the solvent is in the range of 1 to 70 wt.-%, more preferably 2 to 65 wt.-%, most preferably 3 to 60 wt.-%.

Depending on the solvent which was employed for formulating the resist material, the oven temperature and the drying time (curing of the resin material) have to be adjusted. The resulting hardness of the dried coating is important. Measurement of the hardness according to Koenig preferably should be in the range of 20 s to 200 s, more preferably 40 s to 180 s, most preferably 60 s to 160 s.

Now referring to Fig. 2c: a conductive seed layer (205) is deposited onto at least a portion of the plating base (202) exposed by the first openings (204) and onto the outer surface of the patterned first resist layer (203).

The conductive seed layer (205) is required to initiate electroplating the first metal or metal alloy layer (206) into the first openings (204), onto at least a portion of the plating base (202), and on top of the patterned first resist layer (203).

As the conductive seed layer (205) covers the entire surface including the first openings (204) a variation of the local electrical potential is not seen. This kind of panel plating approach does not comprise isolated patterned lines to be electroplated. The variation in layout (position and size of first openings (204)) has no impact on the local electrical potential anymore. The plated metal or metal alloy thickness distribution is now dependent on the thickness accuracy of the applied first resist layer (203). This allows an increase of current density, as no isolated layout features are the limiting factor. An increase in plating speed shortens the required time for depositioning the metals or metal alloys and therefore less plating equipment can be used. Less shop floor is required in the cleanroom environment, which itself saves cost. The same accounts for less air needed for the exhaust systems.

The conductive seed layer (205) is for example formed by electroless plating in the conventional manufacturing of non-conductive surfaces which is well known in the art.

Other suitable methods for depositing the conductive seed layer (205) are for example direct plating using an intrinsically conductive polymer, chemical vapour deposition (CVD), physical vapour deposition (PVD) and plasma enhanced chemical vapour deposition (PECVD).

Preferably, the conductive seed layer (205) is deposited by electroless plating.

According to the present invention, the conductive seed layer (205) is deposited over the entire surface of the solar cell substrate (201) including those parts of the plating base (202) exposed by the first openings (204), and the patterned first resist layer (203) (Fig. 2c).

The surface of the patterned first resist layer (203) can be activated for subsequent electroplating by various methods which are described, for example, in Printed Circuits Handbook, C. F. Coombs Jr. (Ed.), 6th Edition, McGraw Hill, pages 28.5 to 28.9 and 30.1 to 30.11. These processes involve the formation of a conductive layer comprising carbon particles, noble metal colloids, noble metal ions or electrically conductive polymers.

These processes are described in the patent literature and examples are given below:
European patent EP 0 616 053 discloses a process for applying a metal coating to a non-conductive substrate (without an electroless coating) comprising:
   a. contacting said substrate with an activator comprising a noble metal/Group IVA metal sol to obtain a treated substrate;
   b. contacting said treated substrate with a self accelerating and replenishing immersion metal composition having a pH above 11 to pH 13 comprising a solution of;
      (i) a Cu(II), Ag, Au or Ni soluble metal salt or mixtures thereof,
      (ii) a Group IA metal hydroxide,
      (iii) a complexing agent comprising an organic material having a cumulative formation constant log K of from 0.73 to 21.95 for an ion of the metal of said metal salt.

This process results in a thin conductive layer which can be used for subsequent electroplating. This process is known in the art as the "Connect" process.

US 5,503,877 describes the metallization of non-conductive surfaces involving the use of complex compounds for the generation of metal seeds on a non-metallic substrate. These metal seeds provide for sufficient conductivity for subsequent electroplating. This process is known in the art as the so-called "Neoganth" process.

US 5,693,209 relates to a process for metallization of a non-conductive surfaces involving the use of conductive pyrrole polymers. The process is known in the art as the "Compact CP" process.

EP 1 390 568 B1 also relates to direct electrolytic metallisation of non-conductive surfaces. It involves the use of conductive polymers to obtain a conductive layer for subsequent electroplating. The conductive polymers have thiophene units. The process is known in the art as the "Seleo CP" process.

The non-conductive surface can be activated for subsequent electroless plating with a colloidal or an ionogenic palladium ion containing solution, methods for which are described, for example, in Printed Circuits Handbook, C. F. Coombs Jr. (Ed.), 6^{th} Edition, McGraw Hill, pages 28.9 and 30.2 to 30.3.

Subsequent electroless plating of a thin intermediate metal coating can optionally been carried out in order to enhance the conductive seed layer (205). With assistance of the conductive seed layer (205), electroplating of the first metal or metal alloy layer (206) according to the present invention can then be carried out.

The conductive seed layer (205) may be made of a single metal layer, a single metal alloy layer or of a multilayer of at least two distinct single layers. Metals and metal alloys suitable as conductive seed layer (205) are selected from the group consisting of copper, tin, cobalt, nickel, silver, tin alloys such as tin-lead alloy, tin-silver alloy, copper alloys such as copper-nickel alloy, copper-chromium alloy, copper-ruthenium alloy, copper-rhodium alloy, copper-silver alloy, copper-iridium alloy, copper-palladium alloy, copper-platinum alloy, copper-gold alloy and copper-rare earth alloy, copper-nickel-silver alloy, copper-nickel-rare earth metal alloy, nickel alloys such as nickel-phosphorous alloys and nickel-boron alloys, and cobalt alloys such as cobalt-tungsten-phosphorous alloys and cobalt-molybdenum-phosphorous alloys.

Copper, copper alloys, nickel and nickel alloys are most preferred as the conductive seed layer (205).

In accordance with a preferred embodiment of the present invention, said conductive seed layer (205) can also be formed by an electroless plating method, wherein the catalytic metal does not use noble metal but uses copper as the catalytic metal. The typical examples for forming such a catalytic copper on a non-conductive surface can be found in the US 3,993,491 and US 3,993,848.

The thickness of said conductive seed layer (205) preferably is less than 10 µm and more preferably between 0.1 and 5 µm.

Next, a first metal or metal alloy layer (206) is deposited by electroplating onto the conductive seed layer (205) (Fig. 2d).

Preferably, the first metal or metal alloy layer (206) is selected from the group consisting of copper, copper alloys, tin, tin alloys, nickel, nickel alloys, silver and silver alloys. More preferably, the first metal or metal alloy layer (206) is selected from the group comprising copper and copper alloys.

Suitable copper and copper alloy electroplating bath compositions are known in the art. Commonly used copper or copper alloy plating bath compositions and process parameters for plating can be applied. A preferred copper plating bath composition comprises water, a source of copper ions, an acid such as sulfuric acid and/or methane sulfonic acid and one or more organic additives selected from the group consisting of brightener additives, carrier additives, leveler additives, and wetting agents. Other optional additives are for example halide ions such as chloride ions and a source of second metal ions in case a copper alloy should be deposited.

Both DC plating and reverse pulse plating can be used to deposit copper or a copper alloy as the first metal or metal alloy layer (206) onto the conductive seed layer (205).

A particularly suitable apparatus for deposition of the first metal or metal alloy layer (206) is disclosed in WO 2009/15289 A1. In this apparatus for one-sided treatment of the solar cell substrate (201), the substrate (201) is placed without frames, grippers or holders above a vertically arranged treatment chamber so that only the underside of the substrate is wetted by the treatment liquid.

Suitable tin and tin alloy electroplating bath compositions are known in the art. Commonly used tin or tin alloy plating bath compositions and process parameters for plating are described in the following.

Among other components of the tin or tin alloy bath may be added a source of Sn²⁺ ions, an anti-oxidant, and a surfactant.

The source of Sn²⁺ ions may be a soluble tin-containing anode, or, where an insoluble anode is used, a soluble Sn²⁺ ion source. Tin methane sulfonic acid, Sn(MSA)₂, is a preferred source of Sn²⁺ ions because of its high solubility. Typically, the concentration of the source of Sn²⁺ ions is sufficient to provide between 10 g/l and 100 g/l of Sn²⁺ ions into the bath, preferably between 15 g/l and 95 g/l, more preferably between 40 g/l and 60 g/l. For example, Sn(MSA)₂ may be added to provide between 30 g/l and 60 g/l Sn²⁺ ions to the plating bath.

A preferred tin alloy is tin silver alloy. In such case the plating bath additionally contains a soluble silver salt, commonly used are nitrate, acetate, and preferably methane sulfonate. Typically, the concentration of the source of Ag⁺ ions is sufficient to provide between 0.1 g/l and 1.5 g/l of Ag⁺ ions into the bath, preferably between 0.3 g/l and 0.7 g/l, more preferably between 0.4 g/l and 0.6 g/l.

For example, Ag(MSA) may be added to provide between 0.2 g/l and 1.0 g/l Ag⁺ ions to the plating bath.

Anti-oxidants may be added to the tin or tin alloy baths to stabilize the bath against oxidation of Sn²⁺ ions in solution. Preferred anti-oxidants such as hydroquinone, catechol, and any of the hydroxyl, dihydroxyl, or trihydroxyl benzoic acids may be added in a concentration between 0.1 g/l and 10 g/l, preferably between 0.5 g/l and 3 g/l. For example, hydroquinone may be added to the bath at a concentration of 2 g/l.

Surfactants may be added to promote wetting of the substrate. The surfactant seems to serve as a mild deposition inhibitor which can suppress three-dimensional growth to an extent, thereby improving morphology and topography of the film. It can also help to refine the grain size, which yields a more uniform bump. Exemplary anionic surfactants include alkyl phosphonates, alkyl ether phosphates, alkyl sulfates, alkyl ether sulfates, alkyl sulfonates, alkyl ether sulfonates, carboxylic acid ethers, carboxylic acid esters, alkyl aryl sulfonates, aryl alkylether sulfonates, aryl sulfonates, and sulfosuccinates.

The electrolytic tin or tin alloy plating bath of the present invention preferably has an acidic pH to inhibit anodic passivation, achieve better cathodic efficiency, and achieve a more ductile deposit. Accordingly, the bath pH is preferably between 0 and 3. In the preferred embodiment the pH of the bath is 0. Accordingly, the preferred acidic pH can be achieved using nitric acid, acetic acid, and methane sulfonic acid. In one preferred embodiment, the acid is methane sulfonic acid. The concentration of the acid is preferably between 50 g/l and 200 g/l, more preferably between 70 g/l and 120 g/l. For example, between 50 g/l and 160 g/l methane sulfonic acid can be added to the electroplating bath to achieve a bath of pH 0 and act as the conductive electrolyte.

Typical tin or tin alloy bath compositions are for example disclosed in Jordan: The Electrodeposition of Tin and its Alloys, 1995, p. 71-84.

The plating of tin and tin alloys for solder depot plating can be performed by direct current (DC) or reverse pulse plating. The advantages of reverse pulse plating are better surface distribution uniformity and improved crystal structures with tin deposits possessing finer grain sizes and therefore better solderability properties. Also, higher applicable current density and therefore higher throughput can be obtained by reverse pulse plating compared to DC plating.

Generally, current pulses at an effective current density of 1 to 20 A/dm² can be applied. Alternatively, operating of the bath with DC at a current density of 1 to 3 A/dm² can be performed.

For example, applying tin by reverse pulse plating with a current density of 3 A/dm² yields an average thickness of the tin deposit of 40 µm within 30 min. plating time. The thickness variation on the surface is only +/- 15 %. Applying DC plating a maximum current density of only 1 A/dm² can be obtained. Plating time to obtain a thickness of the tin deposit of 40 µm is 86 min. The variation on the surface is +/- 33 %, thus much higher than for reverse pulse plating.

Preferred reverse pulse parameters are as follows:
The ratio of the duration of the at least one forward current pulse to the duration of the at least one reverse current pulse is adjusted to at least 1 : 0 to 1 : 7, preferably to at least 1 : 0.5 to 1 : 4 and more preferably to at least 1 : 1 to 1 : 2.5.

The duration of the at least one forward current pulse can be adjusted to preferably at least 5 ms to 1000 ms.

The duration of the at least one reverse current pulse is preferably adjusted to 0.2 to 5 ms at most and most preferably to 0.5 to 1.5 ms.

The peak current density of the at least one forward current pulse at the workpiece is preferably adjusted to a value of 1 to 30 A/dm² at most. Particularly preferable is a peak current density of the at least one forward current pulse at the workpiece of about 2 to 8 A/dm² in horizontal processes. In vertical processes the most preferred peak current density of the at least one forward current pulse at the workpiece is 1 to 5 A/dm² at most.

The peak current density of the at least one reverse current pulse at the work piece will preferably be adjusted to a value of 0 to 60 A/dm². Particularly preferred is a peak current density of the at least one reverse current pulse at the workpiece of about 0 to 20 A/dm² in horizontal processes. In vertical processes the most preferred peak current density of the at least one forward current pulse at the workpiece is 0 to 12 A/dm² at most.

Since also the patterned first resist layer (203) is covered by the conductive seed layer (205), electroplating of the first metal or metal alloy layer (206) is also on this layer. The thickness of the first metal or metal alloy layer (206) should preferably not exceed 10 µm and more preferably not exceed 6 µm on top of the patterned first resist layer (203).

In step (v) of the method according to the present invention, those parts of the first metal or metal alloy layer (206) which are plated on top of the patterned first resist layer (203) are etched away. At the same time, a similar amount (in terms of thickness of this layer) of the first metal and metal alloy layer (206) plated into the first openings (204) is also etched away. Step (v) of the method according to the present invention is illustrated in Fig. 2e.

In one embodiment of the present invention, no additional etch resist is applied onto the first metal or metal alloy layer (206) above those part(s) of the plating base (202) exposed by the first openings (204) prior to removal of the first metal or metal alloy layer (206).

The term "etch resist" is defined herein as any kind of patterned barrier, e.g., photo imageable or screen printed organic resists and metal etch resists which prevents undesired removal of metallic material beneath said etch resist during etching.

The removal is preferably performed by chemical etching an amount of the first metal or metal alloy layer (206) sufficient to remove the first metal or metal alloy layer (206) from the conductive seed layer (205) leaving a patterned first metal or metal alloy layer (207) in the first openings (204) (Fig. 2e).

In one embodiment of the present invention, an amount of the first metal or metal alloy layer (206) is removed by etching sufficient to remove also a portion of the metal or metal alloy layer (206) inside the first openings (204). This portion may preferably be 0.1 to 10 µm, more preferably 0.5 to 5 µm in terms of thickness of the metal or metal alloy (206) inside the first openings (204).

In case the first metal or metal alloy layer (206) consists of tin and tin alloys, the etching can be performed electrolytically or chemically. Also, mechanical polishing may be applied alone or in combination with electrolytical or chemical stripping to remove the first metal or metal alloy layer (206).

Typical etching or stripping compositions for the first metal or metal alloy layer (206) consisting of tin or tin alloys are for example disclosed in Jordan: The Electrodeposition of Tin and its Alloys, 1995, p. 373-377.

During electrolytic stripping methods tin or its alloys are anodically dissolved in a 10 wt.-% NaOH solution at 70 to 90 °C.

Chemical stripping generally is performed in solutions containing a strong base like NaOH (about 10 wt.-%) at elevated temperatures of 70 to 90 °C. Organic additives, particularly nitroaromatic compounds like p-nitrophenol, may be added to the solution.

Alternatively, chemical stripping can be performed in the following solutions:
- hydrogen peroxide, often with added fluoride,
- systems based on nitric acid and nitrates, 5 to 40 wt.-% of nitrate,
- systems based on HCl / copper chloride, containing 5 to 20 wt.-% HCl with an initial concentration of 2.5 mg/l copper chloride.

In case the first metal or metal alloy layer (206) consists of copper or copper alloys the etching can be performed electrolytically or chemically. Also, mechanical polishing may be applied alone or in combination with electrolytical or chemical stripping to remove the first metal or metal alloy layer (206).

Typical etching or stripping compositions for the first metal or metal alloy layers (206) consisting of copper or copper alloys and a conductive seed layer (205) consisting of copper or a copper alloy are for example disclosed in: C. F. Coombs, Jr., "Printed Circuits Handbook", 5th Ed. 2001, McGraw-Hill, Chapter 33.4.

Suitable etching solutions and etching conditions are chosen in routine experiments.

Next, those parts of the conductive seed layer (205) which are on top of the patterned first resist layer (203) are removed in step (vi) by chemical and/or electrochemical etching (Fig. 2f).

The conductive seed layer (205) can be removed with the same methods as the metal or metal alloy layer (206) in step (v).

The first resist layer (203) is then removed by wet chemical stripping in step (vii) (Fig. 2g).

The patterned first resist layer (203) can be removed (stripped) from the solar cell substrate (201) by contacting the patterned first resist layer (203) with a solvent, the solvent preferably selected from the group comprising acetone, n-amylalcohol, n-amylacetate, benzyl alcohol, 1,4-butanediol, methoxybutyl acetate, n-butylacetate, sec-butyl acetate, n-butanol, 2-butanol, butyldiglycol, butyldiglycol acetate, diethyleneglycol dibutylether, butylglycol, butylgycol acetate, n-butyltriglycol, chloroform, cyclohexane, cyclohexanol, cyclohexanone, cyclohexylamine, n-decane, decahydro naphthalene, diacetone alcohol, 1,2-dichloroethane, 1,2-dichlorobenzene, 1,2-dichloropropane, diethanolamine, diethylene glycol, diethyleneglycol dibutylether, diethyleneglycol diethylether, di-ethyleneglycol dimethylether, diethyleneglycol monobutylether, diethyleneglycol monobutylether. acetate, diethyleneglycol monoethylether, diethyleneglycol monomethylether, diethyleneglycol momethylether acetate, diethylether, diethylketone, diethyleneglycol dimethylether, diisobutylketone, diisopropylamine, diisopropanolamine, diisopropylether, dimethylacetamide, dimethylformamide, dimethylsulfoxide, 1,4-dioxane, dipentene, dipropyleneglycol, dipropyleneglycol monobutylether, dipropyleneglycol monomethylether, n-dodecane, propyleneglycol diacetate, propyleneglycol monomethylether, propyleneglycol monomethylether acetate, propyleneglycol monobutylether, propyleneglycol monobutylether acaetate, tripropyleneglycol monomethylether, tripropyleneglycol monobutylether, ethyl-3-ethoxypropionate, ethanolamine, propyleneglycol monoethylether, ethoxypropyl acetate, ethylacetate, ethaylamylketone, ethylbenzene, 2-ethylbutanol, ethylbutyl ketone, ethyldiglycol, ethyldiglycol acetate, 1,2-dichloroethane, ethyleneglycol, ethyleneglycol dietheylether, ethyleneglycol dimethylether, ethyleneglycol monobutylether, ethyleneglycol monobutylether acetate, ethyleneglycol monoethylether, ethyleneglycol monoethylether acetate, ethyleneglycol monoisopropylether, ethyleneglycolmonomethylether, ethyleneglycol monomethylether acetate, ethyleneglycol monopropylether, ethylformiate, ethylglycol, ethylglycol acetate, ethyleneglycol dietehylether, 2-ethoxyethanol, 2-ethylhexyl acetate, ethyllactate, ethylmethylketone, formic acid, ethylmethylketoxime, ethyltriglycol, furfurol, furfurylalcohol, furfurylaldehyde, glycerol, glycerol triacetate, n-heptane, n-hexadecane, n-hexane, hexylene glycol, isoamyl acetate, isoamylalcohol, isobutylacetate, isobutylalcohol, isoheptane, isooctane, isopentane, isophorone, isopropanolamine, isopropylacetate, isopropylalcohol, isopropylchloride, isopropylether, isopropylglycol, methoxypropyl acetate, methylacetate, methyl alcohol, methylamylketone, methylbutylketone, methylcyclohexane, methylcyclohexanol, methylcyclohexanone, methylcyclopentane, methyldiglycol, methyldiglycol acetate, methylenechloride, acetic acid, methylethylketone, methylethyl ketoxime, methylglycol, methylglycol acetate, methylisoamylalcohol, methylisoamylketone, methylisobutylcarbinol, methylisobutylketone, methylisopropylketone, methylpropylketone, N-methylpyrrolidone, methyl-t-butylether, monochlorobenzene, monoethanolamine, monoisopropanolamine, nitroethane, nitromethane, 1-nitropropane, 2-ntropropane, n-nonane, n-octane, n-octylalcohol, n-pentadecane, pentylpropionate, perchloroethylene, n-propylacetate, n-propanol, propylenedichloride, propyleneglycol, propyleneglycol diacetate, propyleneglycol monobutylether, propyleneglycol monobutyletheracetate, propyleneglycol monoethylether, propyleneglycol monomethylether, propyleneglycol monomethylether acetate, propylglycol, pyridine, sec-butylacetate, n-tetradecane, tetraethyleneglycol, tetraethyleneglycol dimethylether, tetrahydrofurane, tetrahydrofurfurylalcohol, tetrahydro naphthalene, toluene, trichloroethane, trichloroethylene, n-tridecane, triethanolamine, triethyleneglycol, triethethyleneglycol monoethylether, triethyleneglycol dimethylether, tripropyleneglycol, hydrogenperoxide, tripropylengylcol monobutylether, tripropyleneglycol monomethylether, n-undecane, xylene, mesitylene, acetophenone, acetaldehyde, butyrolactone, ethylenecarbonate, propylenecarbonate, acetonitrle, butyronitrile, N-ethylpyrrolidone, and mixtures thereof. Such solvents or mixtures of the aforementioned solvents may further comprise water.

More preferably, the solvent is selected from the group consisting of benzyl alcohol, formic acid, dimethylacetamide, dimethylformamide, cyclohexanone, ethanolamine, triethanolamine, ethyleneglycol monobutylether acetate, ethyleneglycol monoethylether, and mixtures thereof.

Most preferably, the solvent is selected from the group consisting of formic acid, benzyl alcohol, ethyleneglycol monobutylether acetate, ethyleneglycol monoethylether and mixtures thereof.

The patterned first resist layer (203) is contacted with the solvent by immersion, spraying, or dipping. For stripping purpose, the solvent is preferably held at a temperature in the range of 5 to 100 °C, more preferably 10 to 90 °C and most preferably 15 to 80 °C. The contact time during stripping preferably ranges from 1 to 600 s, more preferably from 10 to 540 s and most preferably from 20 to 480 s.

A solar cell substrate comprising a patterned plating base (202) and the patterned first metal or metal alloy layer (207) is shown in Fig. 2g. The patterned first metal or metal alloy layer (207) shows a satisfying homogeneous thickness distribution.

Typical dimensions in terms of conducting line width of a patterned first metal or metal alloy layer (207) preferably range from 1 to 500 µm, more preferably from 5 to 250 µm and most preferably from 5 to 150 µm.

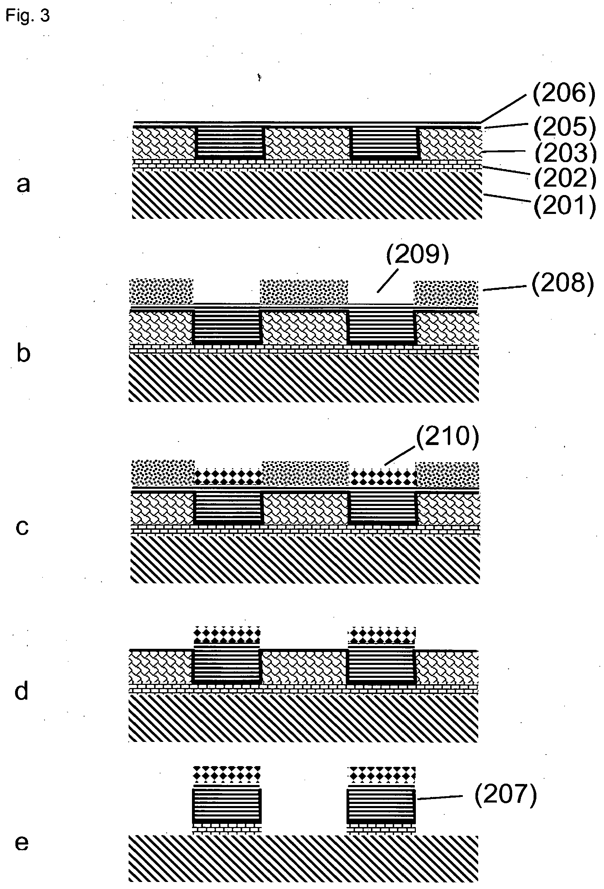

In another embodiment of the present invention (Fig. 3), a second resist layer (208) is deposited onto the first metal or metal alloy layer (206) after step (iv) and patterned in order to form second openings (209) which have the same xy-position (overlap of the patterned first resist layer (203) and the patterned second resist layer (208)) as the first openings (204) (Fig. 3b). The second resist layer (208) can be a liquid resist material, a printable resist material or a dryfilm resist material which may be deposited and patterned by standard methods like in case of the first resist layer (203).

Next, a second metal or metal alloy layer (210) is deposited into the second openings (209) (Fig. 3c). The second metal or metal alloy layer (210) is preferably a solderable and/or bondable metal or metal alloy layer selected from the group consisting of tin, tin alloys such as tin-silver alloys, and silver. The second metal or metal alloy layer (210) is preferably deposited by a method selected from immersion plating, electroless plating and electroplating.

The second resist layer (208) is then stripped by methods known in the art (Fig. 3d). Those portions of the first metal or metal alloy layer (206) which were plated onto the conductive seed layer (205) on top of the patterned first resist layer (203) are removed by etching. The second metal or metal alloy layer (210) serves as an etch resist during removal of the first metal or metal alloy layer (206). Hence, preferably no additional resist layer or other type of etch resist is required in this step.

The conductive seed layer (205) and the patterned first resist layer (203) are then removed in the same way as already described for step (vi).

A patterned first metal or metal alloy layer (207) with a second metal or metal alloy layer (210) on top of said patterned first metal or metal alloy layer (207) is obtained in this embodiment of the present invention (Fig. 3e). Most preferably, the patterned first metal or metal alloy layer (207) is copper or a copper alloy and the second metal or metal alloy layer (210) is tin or a tin alloy.

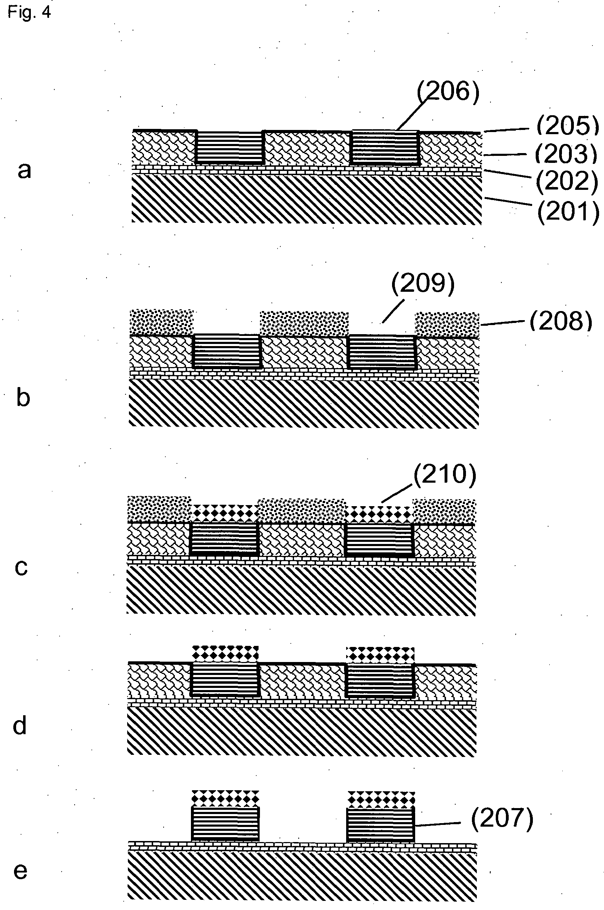

In still another embodiment of the present invention, shown in Fig. 4, a second resist layer (208) is deposited onto the first metal or metal alloy layer (206) after step (v) and patterned in order to provide second openings (209) which have the same xy-position as the first openings (204) (overlap of the patterned first resist layer (203) and the patterned second resist layer (208)) (Fig. 4b).

The second resist layer (208) may be selected from liquid resist materials, printable resist materials, and dryfilm resist materials and may be deposited and patterned by standard methods.

Next, a second metal or metal alloy layer (210) is deposited into the second openings (209). The second metal or metal alloy layer (210) preferably is a solderable layer selected from the group comprising tin, tin alloys such as tin-silver alloys, and silver. The second metal or metal alloy layer (210) is preferably deposited by a method selected from immersion plating, electroless plating and electroplating.

The patterned second resist layer (208) is then stripped by methods known in the art (Fig. 4d).

The conductive seed layer (205) and the patterned first resist layer (203) are then removed in the same way as already described for step (vi) and step (vii), respectively.

A patterned first metal or metal alloy layer (207) with a solderable second metal or metal alloy layer (210) on top of said patterned first metal or metal alloy layer (207) is obtained in this embodiment of the present invention (Fig. 4e). Most preferably, the patterned first metal or metal alloy layer (207) is copper or a copper alloy and the second metal or metal alloy layer (210) is tin or a tin alloy.

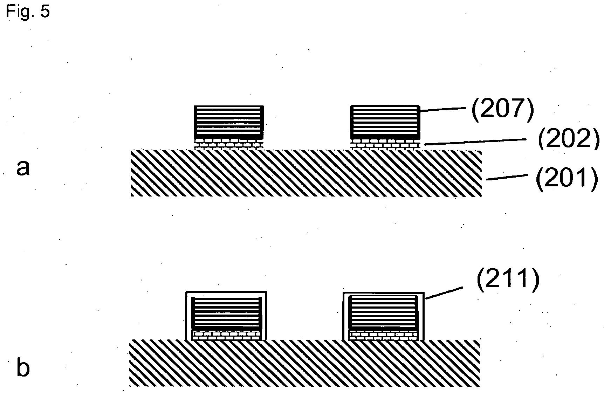

In still another embodiment of the present invention, a patterned first metal or metal alloy layer (207), preferably copper or a copper alloy, is further coated with an organic solderability preservative (OSP) after step (v) by contacting the solar cell substrate with a liquid composition comprising an azole such as benzimidazole (BTA). In case of tin or tin alloys as patterned first metal or metal alloy layer (207) the OSP preferably comprises an organophosphate or - phosphonate compound. The OSP coating is referred herein as a cap layer (211). This embodiment is illustrated in Fig. 5 wherein a solar cell substrate obtained in step (v) is shown in Fig. 5a and the same substrate coated with a cap layer (211) is shown in Fig. 5b.

In yet another embodiment of the present invention, a patterned first metal or metal alloy layer (207), preferably copper or a copper alloy, is further coated with a cap layer (211) comprising a solderable metal or a solderable metal alloy after step (v). Such a solderable metal or solderable metal alloy can be a tin layer, a tin alloy layer such as a tin-silver alloy layer or a silver layer. This solderable cap layer (211) may be deposited by electroless plating or immersion-type plating. Suitable plating bath compositions and methods to deposit such a solderable cap layer (211) onto a patterned first metal or metal alloy layer (207) are known in the art. This embodiment is also illustrated in Fig. 5 wherein a solar cell substrate obtained in step (v) is shown in Fig. 5a and the same substrate wherein the patterned first metal or metal alloy layer (207) is coated with a sol-derable cap layer (211) is shown in Fig. 5b.

A patterned first metal or metal alloy layer (207) selected from copper and copper alloys may be subjected to an adhesion promotion treatment prior to deposition of a polymeric encapsulant such as ethylvinylacetate (EVA) in a later process step. Suitable aqueous compositions for said adhesion promotion treatment may comprise an acid such as sulfuric acid, an oxidant such as hydrogen peroxide and an azole compound. Another suitable aqueous composition comprises hydroxide ions and hypochlorite ions.

## Claims

1. A method for metallization of a solar cell substrate (201) comprising, in this order, the steps of
(i) providing a solar cell substrate (201) having a plating base (202) on at least a portion of one surface of said substrate (201),
(ii) depositing a first resist layer (203) onto the whole substrate (201) including the edges and side walls of said substrate (201) and patterning said first resist layer (203) and thereby forming first openings (204) which expose at least a portion of the plating base (202),
(iii) forming a conductive seed layer (205) on top of the patterned first resist layer (203) and on those portions of the plating base which are exposed by the first openings (204),
(iv) electroplating a first metal or metal alloy layer (206) onto the conductive seed layer (205) formed in step (iii),
(v) etching away an amount of the first metal or metal alloy layer (206) sufficient to remove the first metal or metal alloy layer (206) from the patterned first resist layer (203) leaving a patterned first metal or metal alloy layer (206) in the first openings (204),
(vi) etching away the conductive seed layer (205) from the patterned first resist layer (203), and
(vii) removing the patterned first resist layer (203).

2. The method for metallization of a solar cell substrate (201) according to claim 1 wherein the plating base (202) is selected from the group consisting of doped silicon, metal silicides, one or more thin metal or metal alloy layers, and transparent conductive oxides, with the provisio that metal silicides are only selected for silicon-based solar cell substrates.

3. The method for metallization of a solar cell substrate (201) according to any of the foregoing claims wherein the first resist layer (203) comprises one or more of acrylates, ethylene/ethylacrylate copolymer, ethylene/methacrylate copolymer, ethylene/acrylic acid copolymer, ethylene/butylacrylate copolymer, polymethylpentene, and polymethylmethacrylate.

4. The method for metallization of a solar cell substrate (201) according to claim 3 wherein the first resist layer (203) further comprises a filler selected from the group consisting of aluminium borate, aluminium oxide, aluminiumtrihydroxide, anthracite, sodium antimonate, antimony pentoxide, antimony trioxide, apatite, attapulgite, barium metaborate, barium sulfate, strontium sulfate, barium titanate, bentonite, beryllium oxide, boron nitride, calcium carbonate, calcium hydroxide, calcium sulfate, carbon black, clay, cristobalite, diatomaceous earth, dolomite, ferrites, feldspar, glass beads, graphite, hydrous calcium silicate, iron oxide, kaolin, lithopone, magnesium oxide, mica, molybdenum disulfide, perlite, polymeric fillers such as PTFE, PE, polyimide, pumice, pyrophyllite, rubber particles, fumed silica, fused silica, precipitated silica, sepiolite, quartz, sand, slate flour, talc, titanium dioxide, vermiculite, wood flour, wollastonite, zeolithes, zinc borate, zinc oxide, zinc stannate, zinc sulfide, aramid fibers, carbon fibers, cellulose fibers, and glass fibers, and mixtures thereof.

5. The method for metallization of a solar cell substrate (201) according to any of the foregoing claims wherein the conductive seed layer (205) is formed by electroless plating of a metal or metal alloy.

6. The method for metallization of a solar cell substrate (201) according to any of the foregoing claims wherein the conductive seed layer (205) is selected from the group consisting of copper, copper alloys, nickel, nickel alloys, cobalt, and cobalt alloys.

7. The method for metallization of a solar cell substrate (201) according to any of the foregoing claims wherein the first metal or metal alloy layer (206) is selected from the group consisting of copper, copper alloys, nickel, nickel alloys, tin, tin alloys, silver and silver alloys.

8. The method for metallization of a solar cell substrate (201) according to any of the foregoing claims wherein a second metal or metal alloy layer (210) is deposited between steps (iv) and (v) into second openings (209) formed by a second resist layer (208) formed on at least a portion of the first metal or metal alloy layer (206).

9. The method for metallization of a solar cell substrate (201) according to claim 8 wherein the second metal or metal alloy layer (210) is selected from tin, tin alloys, and silver.

10. The method for metallization of a solar cell substrate (201) according to claims 1 to 7 wherein a second metal or metal alloy layer (210) is deposited between steps (v) and (vi) into second openings (209) formed by a second resist layer (208) formed on at least a portion of the first metal or metal alloy layer (206).

11. The method for metallization of a solar cell substrate (201) according to claim 10 wherein the second metal or metal alloy layer (210) is selected from tin, tin alloys, and silver.

12. The method for metallization of a solar cell substrate (210) according to any of the foregoing claims wherein a cap layer (211) is deposited onto the patterned first metal or metal alloy layer (207) after step (v).

13. The method for metallization of a solar cell substrate according to claim 12, wherein the cap layer (211) is selected from the group comprising azole and derivatives thereof, organophosphate compounds, organo-phosphonate compounds, tin, tin alloys, and silver.

## Patentansprüche

1. Verfahren zum Metallisieren eines Solarzellensubstrats (201), umfassend in dieser Reihenfolge die Schritte
(i) Bereitstellen eines Solarzellensubstrats (201), das eine Plattierungsbasis (202) auf mindestens einem Abschnitt einer Fläche des Substrats (201) aufweist,
(ii) Abscheiden einer ersten Resistschicht (203) auf dem gesamten Substrat (201) einschließlich der Ränder und Seitenwände des Substrats (201) und Strukturieren der ersten Resistschicht (203) und dadurch Bilden von ersten Öffnungen (204), die mindestens einen Abschnitt der Plattierungsbasis (202) freilegen,
(iii)Bilden einer leitenden Bekeimungsschicht (205) oben auf der strukturierten ersten Resistschicht (203) und auf denjenigen Abschnitten der Plattierungsbasis, die durch die ersten Öffnungen (204) freigelegt sind,
(iv) elektrochemisches Abscheiden einer ersten Metall- oder Metalllegierungsschicht (206) auf der leitenden Bekeimungsschicht (205), die in Schritt (iii) gebildet wird,
(v) Wegätzen eines Betrags von der ersten Metall- oder Metalllegierungsschicht (206), der ausreichend ist, um die erste Metall- oder Metalllegierungsschicht (206) von der strukturierten ersten Resistschicht (203) zu entfernen, was eine strukturierte erste Metall- oder Metalllegierungsschicht (206) in den ersten Öffnungen (204) hinterlässt,
(vi) Wegätzen der leitenden Bekeimungsschicht (205) von der strukturierten ersten Resistschicht (203) und
(vii)Entfernen der strukturierten ersten Resistschicht (203).

2. Verfahren zum Metallisieren eines Solarzellensubstrats (201) nach Anspruch 1, wobei die Plattierungsbasis (202) ausgewählt ist aus der Gruppe bestehend aus dotiertem Silizium, Metallsiliziden, einer oder mehreren dünnen Metall- oder Metalllegierungsschichten und transparenten leitenden Oxiden, wobei die Bedingung ist, dass Metallsilizide nur für siliziumbasierte Solarzellensubstrate ausgewählt werden.

3. Verfahren zum Metallisieren eines Solarzellensubstrats (201) nach irgendeinem der vorhergehenden Ansprüche, wobei die erste Resistschicht (203) eines oder mehrere aus Acrylaten, Ethylen/Ethylacrylatcopolymer, Ethylen/Methacrylatcopolymer, Ethylen/Acrylsäurecopolymer, Ethylen/Butylacrylatcopolymer, Polymethylpenten und Polymethylmethacrylat umfasst.

4. Verfahren zum Metallisieren eines Solarzellensubstrats (201) nach Anspruch 3, wobei die erste Resistschicht (203) weiter einen Füller umfasst, der ausgewählt ist aus der Gruppe bestehend aus Aluminiumborat, Aluminiumoxid, Aluminiumtrihydroxid, Anthrazit, Natriumantimonat, Antimonpentoxid, Antimontrioxid, Apatit, Attapulgit, Bariummetaborat, Bariumsulfat, Strontiumsulfat, Bariumtitanat, Bentonit, Berylliumoxid, Bornitrid, Calciumcarbonat, Calciumhydroxid, Calciumsulfat, Kohlenstoffschwarz, Tonerde, Cristobalit, Diatomeenerde, Dolomit, ferritischen Werkstoffen, Feldspat, Glasperlen, Graphit, wasserhaltigem Calciumsilicat, Eisenoxid, Kaolin, Lithopone, Magnesiumoxid, Glimmer, Molybdändisulfid, Perlit, polymeren Füllern wie PTFE, PE, Polyimid, Bimsstein, Pyrophyllit, Gummipartikeln, pyrogener Kieselsäure, Kieselglas, ausgefälltem Siliziumdioxid, Sepiolith, Quarz, Sand, Schiefermehl, Talkum, Titandioxid, Vermiculit, Holzmehl, Wollastonit, Zeolithen, Zinkborat, Zinkoxid, Zinkstannat, Zinksulfid, Aramidfasern, Kohlefasern, Zellulosefasern und Glasfasern und Mischungen davon.

5. Verfahren zum Metallisieren eines Solarzellensubstrats (201) nach irgendeinem der vorhergehenden Ansprüche, wobei die leitende Bekeimungsschicht (205) durch stromloses Abscheiden eines Metalls oder einer Metalllegierung gebildet wird.

6. Verfahren zum Metallisieren eines Solarzellensubstrats (201) nach irgendeinem der vorhergehenden Ansprüche, wobei die leitende Bekeimungsschicht (205) ausgewählt ist aus der Gruppe bestehend aus Kupfer, Kupferlegierungen, Nickel, Nickellegierungen, Kobalt und Kobaltlegierungen.

7. Verfahren zum Metallisieren eines Solarzellensubstrats (201) nach irgendeinem der vorhergehenden Ansprüche, wobei die erste Metall- oder Metalllegierungsschicht (206) ausgewählt ist aus der Gruppe bestehend aus Kupfer, Kupferlegierungen, Nickel, Nickellegierungen, Zinn, Zinnlegierungen, Silber und Silberlegierungen.

8. Verfahren zum Metallisieren eines Solarzellensubstrats (201) nach irgendeinem der vorhergehenden Ansprüche, wobei eine zweite Metall- oder Metalllegierungsschicht (210) zwischen den Schritten (iv) und (v) in zweite Öffnungen (209), die durch eine zweite Resistschicht (208) gebildet sind, die auf mindestens einem Abschnitt der ersten Metall- oder Metalllegierungsschicht (206) gebildet ist, abgeschieden wird.

9. Verfahren zum Metallisieren eines Solarzellensubstrats (201) nach Anspruch 8, wobei die zweite Metall- oder Metalllegierungsschicht (210) ausgewählt ist aus Zinn, Zinnlegierungen und Silber.

10. Verfahren zum Metallisieren eines Solarzellensubstrats (201) nach den Ansprüchen 1 bis 7, wobei eine zweite Metall- oder Metalllegierungsschicht (210) zwischen den Schritten (v) und (vi) in zweite Öffnungen (209), die durch eine zweite Resistschicht (208) gebildet sind, die auf mindestens einem Abschnitt der ersten Metall- oder Metalllegierungsschicht (206) gebildet ist, abgeschieden wird.

11. Verfahren zum Metallisieren eines Solarzellensubstrats (201) nach Anspruch 10, wobei die zweite Metall- oder Metalllegierungsschicht (210) ausgewählt ist aus Zinn, Zinnlegierungen und Silber.

12. Verfahren zum Metallisieren eines Solarzellensubstrats (210) nach irgendeinem der vorhergehenden Ansprüche, wobei eine Capschicht (211) nach Schritt (v) auf der strukturierten ersten Metall- oder Metalllegierungsschicht (207) abgeschieden wird.

13. Verfahren zum Metallisieren eines Solarzellensubstrats nach Anspruch 12, wobei die Capschicht (211) ausgewählt ist aus der Gruppe, die Azol und Ableitungen davon, Organophosphatverbindungen, Organophosphonatverbindungen, Zinn, Zinnlegierungen und Silber umfasst.

## Revendications

1. Procédé de métallisation d'un substrat de cellule solaire (201) comprenant, dans cet ordre, les étapes consistant à
(i) se procurer un substrat de cellule solaire (201) ayant une base de revêtement (202) sur au moins une partie d'une surface dudit substrat (201),
(ii) déposer une première couche de réserve (203) sur la totalité du substrat (201), y compris les bords et les parois latérales dudit substrat (201), et graver ladite première couche de réserve (203) et former ainsi des premières ouvertures (204) qui exposent au moins une partie de la base de revêtement (202),
(iii) former une couche de germination conductrice (205) au-dessus de la première couche de réserve gravée (203) et sur les parties de la base de revêtement qui sont exposées par les premières ouvertures (204),
(iv) déposer électrolytiquement une première couche de métal ou d'alliage métallique (206) sur la couche de germination conductrice (205) formée à l'étape (iii),
(v) décaper une quantité de la première couche de métal ou d'alliage métallique (206) suffisante pour retirer la première couche de métal ou d'alliage métallique (206) de la première couche de réserve gravée (203) en laissant une première couche de métal ou d'alliage métallique gravée (206) dans les premières ouvertures (204),
(vi) décaper la couche de germination conductrice (205) de la première couche de réserve gravée (203), et
(vii) retirer la première couche de réserve gravée (203).

2. Procédé de métallisation d'un substrat de cellule solaire (201) selon la revendication 1 dans lequel la base de revêtement (202) est choisie dans le groupe constitué par le silicium dopé, les siliciures métalliques, une ou plusieurs couches minces de métal ou d'alliage métallique, et les oxydes conducteurs transparents, à condition que les siliciures métalliques soient uniquement choisis pour des substrats de cellules solaires à base de silicium.

3. Procédé de métallisation d'un substrat de cellule solaire (201) selon l'une quelconque des revendications précédentes dans lequel la première couche de réserve (203) comprend un ou plusieurs composés parmi les acrylates, le copolymère éthylène/acrylate d'éthyle, le copolymère éthylène/méthacrylate, le copolymère éthylène/ acide acrylique, le copolymère éthylène/acrylate de butyle, le polyméthylpentène, et le polyméthacrylate de méthyle.

4. Procédé de métallisation d'un substrat de cellule solaire (201) selon la revendication 3 dans lequel la première couche de réserve (203) comprend en outre une charge choisie dans le groupe constitué par le borate d'aluminium, l'oxyde d'aluminium, le trihydroxyde d'aluminium, l'anthracite, l'antimonate de sodium, le pentoxyde d'antimoine, le trioxyde d'antimoine, l'apatite, l'attapulgite, le métaborate de baryum, le sulfate de baryum, le sulfate de strontium, le titanate de baryum, la bentonite, l'oxyde de béryllium, le nitrure de bore, le carbonate de calcium, l'hydroxyde de calcium, le sulfate de calcium, le noir de carbone, l'argile, la cristobalite, la terre de diatomées, la dolomite, les ferrites, le feldspath, les billes de verre, le graphite, le silicate de calcium hydraté, l'oxyde de fer, le kaolin, le lithopone, l'oxyde de magnésium, le mica, le disulfure de molybdène, la perlite, les charges polymères telles que le PTFE, le PE, le polyimide, la pierre ponce, la pyrophyllite, les particules du caoutchouc, la silice pyrogénée, la silice fondue, la silice précipitée, la sépiolite, le quartz, le sable, la poudre d'ardoise, le talc, le dioxyde de titane, la vermiculite, la farine de bois, la wollastonite, les zéolithes, le borate de zinc, l'oxyde de zinc, le stannate de zinc, le sulfure de zinc, les fibres d'aramide, les fibres de carbone, les fibres cellulosiques et les fibres de verre, et les mélanges de ceux-ci.

5. Procédé de métallisation d'un substrat de cellule solaire (201) selon l'une quelconque des revendications précédentes dans lequel la couche de germination conductrice (205) est formée par dépôt autocatalytique d'un métal ou d'un alliage métallique.

6. Procédé de métallisation d'un substrat de cellule solaire (201) selon l'une quelconque des revendications précédentes dans lequel la couche de germination conductrice (205) est choisie dans le groupe constitué par le cuivre, les alliages de cuivre, le nickel, les alliages de nickel, le cobalt, et les alliages de cobalt.

7. Procédé de métallisation d'un substrat de cellule solaire (201) selon l'une quelconque des revendications précédentes dans lequel la première couche de métal ou d'alliage métallique (206) est choisie dans le groupe constitué par le cuivre, les alliages de cuivre, le nickel, les alliages de nickel, l'étain, les alliages d'étain, l'argent et les alliages d'argent.

8. Procédé de métallisation d'un substrat de cellule solaire (201) selon l'une quelconque des revendications précédentes dans lequel une deuxième couche de métal ou d'alliage métallique (210) est déposée entre les étapes (iv) et (v) dans des deuxièmes ouvertures (209) formées par une deuxième couche de réserve (208) formée sur au moins une partie de la première couche de métal ou d'alliage métallique (206).

9. Procédé de métallisation d'un substrat de cellule solaire (201) selon la revendication 8 dans lequel la deuxième couche de métal ou d'alliage métallique (210) est choisie parmi l'étain, les alliages d'étain, et l'argent.

10. Procédé de métallisation d'un substrat de cellule solaire (201) selon les revendications 1 à 7 dans lequel une deuxième couche de métal ou d'alliage métallique (210) est déposée entre les étapes (v) et (vi) dans des deuxièmes ouvertures (209) formées par une deuxième couche de réserve (208) formée sur au moins une partie de la première couche de métal ou d'alliage métallique (206).

11. Procédé de métallisation d'un substrat de cellule solaire (201) selon la revendication 10 dans lequel la deuxième couche de métal ou d'alliage métallique (210) est choisie parmi l'étain, les alliages d'étain, et l'argent.

12. Procédé de métallisation d'un substrat de cellule solaire (201) selon l'une quelconque des revendications précédentes dans lequel une couche d'encapsulation (211) est déposée sur la première couche de métal ou d'alliage métallique gravée (207) après l'étape (v).

13. Procédé de métallisation d'un substrat de cellule solaire (201) selon la revendication 12, dans lequel la couche d'encapsulation (211) est choisie dans le groupe comprenant l'azole et ses dérivés, les composés d'organophosphate, les composés d'organophosphonate, l'étain, les alliages d'étain, et l'argent.
